# EUROPÄISCHE PATENTSCHRIFT

(11) **EP 2 663 999 B1**
(45) Veröffentlichungstag und Bekanntmachung des Hinweises auf die Patenterteilung: **24.06.2015**
(21) Anmeldenummer: 12700126.1
(22) Anmeldetag: 11.01.2012
(51) Int. Cl.: H01L 23/373, H01L 31/052, H01L 23/473, G06F 1/20, H05K 5/00

(54) **ANORDNUNG UND VERFAHREN ZUM KÜHLEN EINES TRÄGERS**
ARRANGEMENT AND METHOD FOR COOLING A SUPPORT
ENSEMBLE ET PROCÉDÉ POUR REFROIDIR UN SUPPORT

(30) Priorität: 14.01.2011 DE 102011000140; 02.02.2011 DE 102011000455
(43) Veröffentlichungstag der Anmeldung: 20.11.2013
(73) Patentinhaber: AZURSPACE Solar Power GmbH, 74072 Heilbronn (DE)
(72) Erfinder: LÖCKENHOFF, Rüdiger, 74321 Bietigheim-Bissingen (DE)
(74) Vertreter: Stoffregen, Hans-Herbert
(86) Internationale Anmeldenummer: PCT/EP2012/050334
(87) Internationale Veröffentlichungsnummer: WO 2012/095437

(56) Entgegenhaltungen:
- WO-A1-2008/089711
- DE-U1-202004 008 563
- US-B1- 6 837 236
- BAYERER R ET AL: "LEISTUNGSHALBLEITERMODULE IN DIREKT-BONDING-TECHNIK", TECHNISCHE RUNDSCHAU, HALLWAG AG, CH, Bd. 80, Nr. 32, 5. August 1988 (1988-08-05), Seiten 38-41,43,45, XP000110807, ISSN: 1023-0823

## Beschreibung

Die Erfindung bezieht sich auf eine Anordnung zum Kühlen eines zumindest ein elektrisches und/oder elektronisches Bauelement aufweisenden Trägers umfassend ein einen Innenraum aufweisendes Gehäuse mit
- einer den Boden des Gehäuses bildenden Grundplatte, wobei auf der Grundplatte der Träger abgestützt ist und zwischen dem Träger und der Grundplatte ein Kühlfluid führende Kanäle verlaufen, die mit zumindest einer Einlass- und zumindest einer Auslassöffnung verbunden sind,
- einer den Träger umgebenden Umfangswandung und
- einer oberhalb des Trägers verlaufenden und den Innenraum des Gehäuses verschließenden Abdeckung.

Auch nimmt die Erfindung Bezug auf ein Verfahren zum Kühlen eines zumindest ein elektrisches und/oder elektronisches Bauelement aufweisenden Trägers, wobei der Träger in einem einen Innenraum aufweisenden Gehäuse mit
- einer den Träger über Abstandselemente abstützenden Boden des Gehäuses bildenden Grundplatte,
- einer den Träger umgebenden Umfangswandung sowie
- einen den Innenraum des Gehäuses verschließenden, vorzugsweise transparenten, Abdeckung angeordnet wird, wobei zwischen dem. Träger und der Grundplatte ein Zwischenraum vorhanden ist, der mit einem Kühlfluid durchströmt wird, mittels dessen der Träger mit einem Druck P1 beaufschlagt wird.

Der WO-A-2010/012491 ist ein offenes verkapseltes Konzentratorsystem für Solarstrahlung zu entnehmen. Dabei wird nach einem Ausführungsbeispiel ein Photovoltaikmodul in einem quaderförmigen Gehäuse angeordnet, das eine Doppelwandung aufweist, durch die ein Kühlfluid strömt. Strahlseitig ist das Gehäuse von Glasschichten verschlossen. Ferner ist das Modul auf einem Kühlkörper angeordnet, an dessen Unterseite Kühlwasser entlangströmt.

Nach der WO-A-2003/095922 (EP-A-1 790 935) wird in Mäandern Kühlwasser durch ein Gehäuse geleitet, an dessen Abdeckung ein Halbleiterbauelemente aufweisendes Substrat angeordnet werden kann, um dieses zu kühlen. Die diesbezügliche Anordnung ist zur Kühlung von z.B. Direct Copper Bonding (DCB)-Platinen geeignet, wobei das Kühlwasser diese nicht unmittelbar beaufschlagt, da anderenfalls die Gefahr eines Brechens besteht.

Ein Halbeitermodul ist der EP-A-0 411 119 zu entnehmen. Zum Kühlen des Moduls wird dieses auf einem Träger angeordnet und von einer Kühlplatte abgedeckt, entlang der ein Kühlfluid geführt wird. Die Leitungen des Kühlfluids sind von einem Gehäuse umgeben, das gegenüber dem Träger abgedichtet ist. Um das Austreten von Kühlfluid zu vermeiden, wird das Gehäuse von einem Gas durchströmt, dessen Druck größer als der des Kühlfluids ist.

Aus der US-A-2006/0 138 452 ist ein Leistungshalbleitermodul mit einem Gehäuse und einer darin angeordneten Halbleiterschicht bekannt. Die Halbleiterschicht ist zwischen Grundplatten angeordnet, die ihrerseits elektrisch leitende streifenförmige Elektrodenanschlusselemente kontaktieren. In dem Gehäuse sind Kühlkörper angeordnet, die mit den Elektrodenanschlusselementen zum Kühlen dieser thermisch leitend verbunden sind.

Der WO-A-2008/089711 ist eine Vorrichtung zur Kühlung von Bauelementen zu entnehmen, die auf einem Substrat angeordnet sind. Das Substrat wird mittels eines Kühlfluids gekühlt. Um ein Durchbiegen des Substrats aufgrund des einwirkenden Kühlfluids zu unterbinden, wird über Rippen eines Gehäuses ein Gegendruck erzeugt, die sich auf einer Vergussmasse abstützen, die das Bauelemente umgibt.

Die Literaturstelle Dr. R. Bayerer et al.: "Leistungshalbleitermodule in Direkt-Bonding-Technik", Technische Rundschau, Hallwag AG, CH, vol. 80, No. 32, 5. August 1988 (1988-08-05), Seiten 38-41, 43, 45, beschreibt Leistungshalbleitermodule, die ein auf einem Kühlkörper angeordnetes Substrat aufweisen. Auf den Kühlkörper ist ein Kunststoffgehäuse schraubbar, das das Leistungshalbleitermodul umgibt und mit einer Vergussmasse ausgefüllt ist.

Die DE-U-20 2004 008 563 bezieht sich auf ein Solarmodul mit einem Substratträger aus Keramik, der auf einem Kühlkörper angeordnet ist.

Der vorliegenden Erfindung liegt die Aufgabe zugrunde, die Nachteile des Stands der Technik bei der Verwendung insbesondere großflächiger Träger z.B. einer Fläche zwischen 30 cm² und 200 cm² oder mehr zu vermeiden. Insbesondere ist es Aufgabe der vorliegenden Erfindung, eine Anordnung und ein Verfahren der eingangs genannten Art so weiterzubilden, dass ein Träger unmittelbar mit einem Kühlfluid beaufschlagt werden kann, auch dann, wenn der Träger bruchempfindlich ist wie z.B. eine Direct Copper Bonding (DCB)-Platine, auf der zur Bildung eines Moduls Solarzellen verschaltet sind, insbesondere Konzentratorsolarzellen.

Zur Lösung der Aufgabe ist im Wesentlichen vorgesehen, dass der Innenraum mit einem Gas mit einem Druck beaufschlagt ist, der größer als der durch das Kühlfluid erzeugte und auf den Träger einwirkende Druck ist.

Die erfindungsgemäße Lehre ist insbesondere für all die Fälle anwendbar, bei denen auf Träger elektronische Bauelemente wie Solarzellen angeordnet sind, die zu einer hohen Verlustleistung neigen.

Insbesondere befasst sich die Erfindung mit der Kühlung von Konzentratorsolarzellenmodulen. Entsprechende Module werden im konzentrierten Sonnenlicht benutzt, das durch Parabolspiegel oder heliostate Spiegelfelder erzeugt wird. Hierdurch werden sehr hohe Lichtintensitäten im Bereich von 10 W/cm² bis 200 W/cm² in elektrische Energie umgewandelt. Die thermische Verlustleistung dieser Module liegt im Bereich zwischen 5 W/cm² und 200 W/cm² und ist mit der in der Hochleistungselektronik vergleichbar. Allerdings werden bei der Hochleistungselektronik Verlustleistungen auf nur einigen Quadratzentimetern erzeugt, wohingegen bei Konzentratoiphotovoltaikmodulen die thermischen Verluste im Bereich von 30 cm² bis 200 cm² erzeugt werden, so dass Gesamtverlustleistungen von mehreren Kilowatt auftreten.

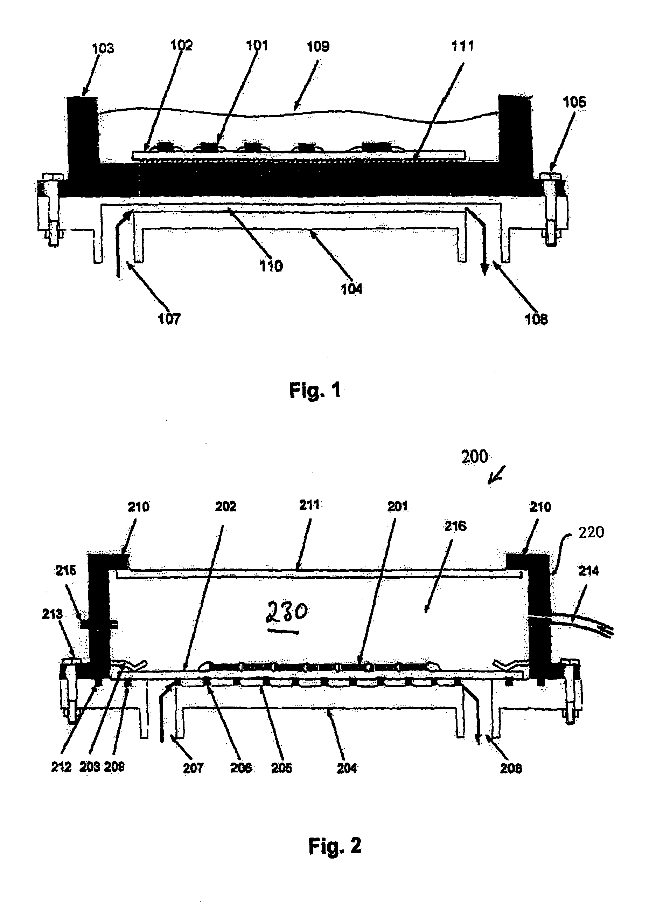

Elektronische Hochleistungskomponente 101 können auf Direct Copper Bonded Keramik (DCB)-Platinen angeordnet werden, wie dies beispielhaft anhand der Fig 1 verdeutlicht werden soll, die einem Stand der Technik entspricht, wie dieser " I. Koch, N. Lescow: Vergleich verschiedener Methoden der Flüssigkeitskühlung, Jahresbericht 2008, Institut für Elektrische Maschinen, Antriebe und Bahnen" zu entnehmen ist. Dabei kann ein Träger 102 auf einer Metallplatte eines Gehäuses 103 angeordnet und mittels einer Lötschicht mit dieser verbunden werden. Die Platte weist eine gute thermische Leitfähigkeit auf und verteilt die Wärme über eine größere Fläche. Um die Komponenten 101 zu schützen, ist das topfförmige offene Metallgehäuse 103 mit Weichsilicon 109 gefüllt.

Das Gehäuse 103 bzw. die Metall- oder Grundplatte ist auf einen Wasserkühler 104 geschraubt, wobei ein Kraftschluss zwischen dem Gehäuse 103 und dem Wasserkühler 104 derart erfolgt, dass ein guter thermischer Kontakt hergestellt ist. Zur weiteren Verbesserung des Kontakts kann ein Wärmefett zugeführt werden. Über Einlassöffnungen 104 gelangt Wasser in den Wasserkühler 104, durchströmt diesen durch eine oder mehrere Kanäle 110, um von dem auf der Platte angeordneten Träger 101 Wärme abzuführen.

Dabei können die Kanäle derart gestaltet werden, dass die Oberfläche vergrößert und Turbulenzströmungen erzeugt werden: Das Wasser wird über eine oder mehrere Auslassöffnungen 108 abgeführt.

Eine diesbezügliche Anordnung ist für die Hochleistungselektronik geeignet, jedoch nicht für Hochkonzentratorsolarzellenmodule mit einer Fläche im Bereich zwischen 20 cm² und 200 cm² im Vergleich zu Hochleistungselektronikanordnungen von wenigen cm².

Bei der Hochleistungselektronik werden die DCB-Platinen mit der z.B. aus Kupfer bestehenden Grundplatte durch Löten verbunden, um die Wärme abzuführen. Da der Wärmeausdehnungskoeffizient für Kupfer wesentlich höher als für Keramik ist, ist bei Temperaturwechselbeanspruchungen bei großflächigen Verbindungen ein Beschädigen der Lötschicht festzustellen. Daher ist es nicht möglich, z.B. die eine Keramikschicht enthaltenden DCB-Platinen mit einer Fläche von 10 cm x 10 cm auf einer massiven Kupferplatte aufzulöten.

Ein weiterer Nachteil bei großflächigen Verbindungen zwischen Träger und Gehäuse bzw. Platte ist darin zu sehen, dass im erforderlichen Umfang ein flächiger Kontakt zwischen dem Gehäuse und dem Träger nicht sichergestellt ist, vielmehr treten Lücken auf, durch die der Wärmeübergang reduziert wird mit der Folge, dass eine ungleichmäßige Temperaturverteilung auftritt.

Aufgrund der erfindungsgemäßen Lehre ist es nicht erforderlich, dass der Träger mit einem Gehäuse bzw. eine Platte im Bereich der Bauelemente stoffschlüssig verbunden wird. Vielmehr besteht die Möglichkeit, den Träger unmittelbar mit Kühlfluid wie Kühlwasser oder sonstige Kühlflüssigkeiten wie Glycerin/Wassergemisch zu beaufschlagen, ohne dass die Gefahr besteht, dass der Träger aufgrund des Drucks des Kühlfluids bricht; denn der von oben auf den Träger einwirkende Druck ist zumindest gleich, insbesondere aber größer als der von dem Kühlfluid auf den Träger einwirkende Druck.

Mit konstruktiv einfachen Maßnahmen besteht die Möglichkeit, großflächige Träger unmittelbar mittels einer Kühlfluidbeaufschlagung zu kühlen, ohne dass die Gefahr eines Brechens besteht.

Dabei ist insbesondere vorgesehen, dass der Druck im Innenraum des Gehäuses zwischen 0,2 bar bis 1 bar über dem Druck liegt, der von Seiten des Kühlfluids auf den Träger einwirkt. Das Kühlfluid wie Flüssigkeit wird vorzugsweise mit einem Druck zwischen 0,2 bar und 1 bar über Atmosphärendruck in den Zwischenraum zwischen dem Träger und der die Bodenwandung des Gehäuses bildenden Grundplatte eingeführt, wobei Fließgeschwindigkeiten im Bereich zwischen 0,3 m/sec und 1 m/sec zu bevorzugen sind.

Das Kühlfluid durchströmt den Zwischenraum zwischen der Grundplatte und dem Träger durch Kanäle, die durch insbesondere stegförmige Vorsprünge begrenzt werden, die von der Grundplatte ausgehen. Alternativ oder ergänzend können entsprechende Vorsprünge auch von der Unterseite des Trägers ausgehen. Hierzu weist der Träger eine entsprechende Ausgestaltung auf. Insbesondere werden die Vorsprünge des Trägers aus Abschnitten einer unterseitig auf dem Träger vorhandenen Metallisierung bzw. durch auf die Unterseite des Trägers aufgebrachte Vorsprünge gebildet.

Eine diesbezügliche Gestaltung ist problemlos bei DCB-Platinen möglich, wobei in Abhängigkeit von der Form und Herstellung der auch als Finnen zu bezeichnenden Vorsprünge die Metallisierung unterschiedliche Dicken aufweist bzw. auf die Metallisierung insbesondere in Maskentechnik Vorsprünge ausgebildet werden, die in den Zwischenraum zwischen dem Träger und der Grundplatte hineinragen. Hierdurch wird die den Wärmeübergang ermöglichende Fläche des Trägers vergrößert. Gleichzeitig wird das durch die Kanäle strömende Kühlfluid in Turbulenz versetzt, so dass der Kühleffekt erhöht wird.

Maßnahmen, entsprechende Vorsprünge an der Unterseite des Trägers auszubilden, können sein:
- Galvanisieren mittels Maskiertechnik,
- stromloses Abscheiden von Metall mittels Maskierung,
- mechanisches Bearbeiten der Metallisierung zur Ausbildung der Vorsprünge oder
- Befestigen von entsprechenden Vorsprüngen aus Metall wie Metallstreifen, die stoffschlüssig mit der Unterseite des Trägers verbunden werden.

Da der Träger unmittelbar von dem Kühlfluid beaufschlagt wird und somit der Träger gegenüber diesem und dem Gehäuse abzudichten ist, bestünde die Möglichkeit, dass Kühlfluid in den Innenraum des Gehäuses eindringt. Dies ist jedoch aufgrund der erfindungsgemäßen Lehre grundsätzlich ausgeschlossen, da der Druck im Innenraum grundsätzlich höher als der des auf den Träger einwirkenden Kühlfluids ist.

Hingegen ist eine Diffusion von Bestandteilen des Kühlmediums durch die Dichtung nicht völlig zu vermeiden. Damit besteht die Gefahr einer langsamen aber beständigen Feuchtigkeitsanreicherung im Volumen bis hin zur Kondensation von Feuchtigkeit bei abfallender Temperatur.

Zur Vermeidung der Feuchtigkeitsanreicherung besteht die Möglichkeit eines Durchströmens des Innenraums von dem den Innenraum beaufschlagenden Gas wie Luft oder Stickstoff, wodurch etwaige Feuchtigkeit abtransportiert werden kann. Hierzu weist das Gehäuse, insbesondere die Umfangswandung des Gehäuses, ein entsprechendes Entlüftungsventil auf.

Der Überdruck innerhalb des Volumens wird durch die Zuleitung von Gas, vorzugsweise Stickstoff, durch eine Einlassöffnung aufrechterhalten. Zusätzlich ist es möglich, das Volumen mit einem Druckausgleichsbehälter zu verbinden, welcher die Druckschwankungen bei schwankender Temperatur im Volumen vermindert.

Das Gas sollte getrocknet sein bzw. eine relative Luftfeuchtigkeit zwischen 0 % und 60 % aufweisen.

Ein Verfahren der eingangs genannten Art zeichnet sich insbesondere dadurch aus, dass der Innenraum mit einem Gas mit einem Druck P2 mit P2 ≥ P1 beaufschlagt wird.

Bevorzugterweise schlägt die Erfindung vor, dass der Druck P2 auf einen Wert 1,2 P1 bis 2 P1 eingestellt wird.

In Weiterbildung ist vorgesehen, dass das Kühlfluid mit einem Druck P mit 0,2 bar ≤ P

≤ 1 bar über Atmosphärendruck in den Zwischenraum eingeleitet wird und/oder Fließgeschwindigkeit V des dem Zwischenraum zugeführten Kühlfluids eingestellt wird auf 0,3 m/sec ≤ V ≤ 1 m/sec.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine Kühlanordnung nach dem Stand der Technik,
- Fig. 2: eine erfindungsgemäße Anordnung zum Kühlen eines Trägers,
- Fig. 3: eine Unterseite eines Trägers,
- Fig. 4a)-c): Herstellungsschritte zur Ausbildung von Vorsprüngen und
- Fig. 5: eine weitere Ausführungsform eines Trägers.

Der Fig. 2 ist eine erfindungsgemäße Anordnung zur Kühlung eines Trägers 202 rein prinzipiell zu entnehmen. Bei dem Träger 202 kann es sich um eine Keramikplatte handeln, die unterseitig eine Metallisierung, insbesondere aus Kupfer, und oberseitig eine Leiterbandstruktur z. B. aus Kupfer aufweist, um Solarzellen 201zu verschalten. Die Solarzellen 201 und der Träger 202 - bei dem es sich insbesondere um eine DCB-Platine handelt - bilden ein Modul, wobei erfindungsgemäß insbesondere ein Hochkonzentratorsolarzellenmodul gekühlt werden soll.

Der Träger 202 ist in einem Gehäuse 200 angeordnet, und zwar auf einer die Funktion eines Bodens des Gehäuses 200 ausübenden Metallplatte 204 z.B. aus Kupfer oder Aluminium. Auf der Boden- oder Metallplatte 204 wird eine Haube 210 über Schrauben befestigt, wobei über mittels eines Dichtelements wie O-Rings 212 eine Abdichtung zwischen der Haube 210 und der Grundplatte 204 erfolgt. Die Haube 210 setzt sich aus einer Umfangswandung 220 und einem aus einer sich oberhalb und im Abstand zu dem Träger 202 erstreckenden transparenten Abdeckung 211 zusammen. Der Abstand zwischen der Oberseite der Solarzellen 201 und der Unterseite der Abdeckung 211 kann im Bereich zwischen 1 mm und 20 cm liegen.

Die Fläche des Trägers 202, der auch als Platine bezeichnet werden kann, liegt zwischen 3 cm x 3 cm bis vorzugsweise 20 cm x 20 cm auf, gleichwenn auch größere Träger 202 in Frage kommen können. Die zu einem Modul verschalteten Solarzellen 201 weisen eine geringere Fläche als die des Trägers 202 auf. Der Träger 202 ist des Weiteren über Sicherungen wie Klemmelemente 203 in Richtung der Grundplatte 204 kraftbeaufschlagt, wobei im Randbereich eine Dichtung wie O-Ring 209 verläuft.

Bei dem Träger 202 handelt es sich insbesondere um eine Direct Copper Bonding (DCB)-Platine, die üblicherweise eine Fläche von mehr als 10 cm x 10 cm aufweist und aufgrund der erfindungsgemäßen Lehre unmittelbar wassergekühlt wird.

Wie sich aus der zeichnerischen Darstellung ergibt, wird die Grundplatte 204 von einem oder mehreren Einlässen 207 und einem oder mehreren Auslässen 208 durchsetzt. Über den Einlass 207 wird einem zwischen der Unterseite des Trägers 202 und der Oberseite der Grundplatte 204 verlaufenden Zwischenraum ein Kühlfluid wie Kühlwasser oder z.B. Glycerin/Wassergemisch zugeführt, um Verlustwärme von dem Träger - auch Trägerplatte 202 genannt - abzuführen. Hierzu verlaufen in dem Zwischenraum zwischen der Trägerplatte 202 und der Grundplatte 204 Kanäle 205, die von Vorsprüngen 206 begrenzt sind, über die der Träger 202 auf der Grundplatte 204 abgestützt ist. Die Vorsprünge 206 können von der Grundplatte 205 oder von der Unterseite des Trägers 202 ausgehen. Es besteht jedoch auch die Möglichkeit, dass sowohl von der Gruridplatte 205 als auch von dem Träger 202 Vorsprünge ausgehen, die sodann beabstandet zueinander ineinander greifen.

Weiterhin besteht die Möglichkeit, dass Abstandshalter in den Spalt zwischen der Grundplatte 204 und dem Träger 202 eingelegt werden, die gegebenenfalls die Vorsprünge ersetzen oder diese ergänzen.

Insbesondere ist vorgesehen, dass von der Rückseite des Trägers 202 0,5 mm bis 5 mm hohe Mikrofinnen als Vorsprünge ausgehen, über die das durch die Kanäle 205 strömende Fluid wie Wasser bzw. Glycerin/Wassergemisch verteilt und eine turbulente Strömung erzeugt wird. Gleichzeitig wird die Kontaktfläche der Rückseite des Trägers 202 mit dem Kühlfluid erhöht. Bevorzugterweise verlaufen die von dem Träger 202 ausgehenden Vorsprünge wie Finnen schräg in Richtung der Wasserströmung gerichtet, wodurch der Turbulenzeffekt erhöht wird.

Das Ausbilden der von der Unterseite des Trägers 202 abragenden Vorsprünge bzw. der Mikrofinnen kann z.B. auf eine der folgenden Weise realisiert werden:
- Die Finnen werden durch Galvanik auf der Rückseitenmetallisierung, die aus Kupfer oder Aluminium bestehen kann, aufgewachsen. Eine Maske mit feinen Spalten definiert dabei die Struktur.
- Die Finnen werden aus der Rückseitenmetallisierung auf der Leiterplatte herausgeschält.
- Die Finnen werden aus einer dicken Rückseitenmetallisierungsschicht herausgeätzt.
- Die Finnen werden auf der Rückseite angeschweißt oder angelötet. Hierzu können entsprechende Metallbändchen benutzt werden.

Bei der Abdeckung 211 kann es sich um ein Weißglas oder Quarzglas handeln. Die Abdeckung 211 ist gegenüber der Umfangswandung 220 mechanisch fixiert und durch eine hochtemperaturbeständige Dichtung abgedichtet, so dass der Innenraum 230 gegenüber der Umgebung abgedichtet ist.

Um zu verhindern, dass aufgrund des durch die Kanäle 205 strömenden Kühlfluids und der damit verbundenen Druckbeaufschlagung der Träger 202 bricht, ist erfindungsgemäß vorgesehen, dass der Innenraum 230 über eine Öffnung 214 mit einem Gas wie Stickstoff derart beaufschlagt wird, dass der Innenraum 230 gegenüber dem von dem Kühlfluid auf den Träger 202 einwirkenden Druck mit Überdruck beaufschlagt wird, so dass der Träger 202 nicht brechen kann. Insbesondere ist vorgesehen, dass der Innenraum 230 gegenüber dem von dem Kühlfluid erzeugten Druck mit einem Überdruck von 0,2 bar bis 1 bar beaufschlagt wird.

Das Kühlfluid kann mit einem Überdruck im Bereich von vorzugsweise 0,2 bar bis 1 bar gegenüber Atmosphärendruck über die Zuleitung 207 dem Zwischenraum zugeführt werden. Die Fließgeschwindigkeit des Fluids sollte zwischen 0,3 m/sec und 1 m/sec liegen.

Dadurch, dass im Innenraum 230 gegenüber dem von der Kühlflüssigkeit erzeugten Druck ein Überdruck herrscht, ist sichergestellt, dass Flüssigkeit in den Innenraum 230 nicht eindringen kann. Zusätzlich wird bei einer Eindiffusion von Feuchtigkeit in den Innenraum sichergestellt, dass ungeachtet dessen in dem Innenraum 230 eine trockene Atmosphäre herrscht, da über ein Entlüftungsventil 215 fortwährend Gas aus dem Innenraum 230 abgeführt wird.

Der Gegendruck in dem Innenraum 230 ermöglicht eine Wasserkühlung insbesondere großflächiger Keramikträger, die anderenfalls unvermeidlich aufgrund des herrschenden Wasserdrucks bersten würden.

Die einen Teil der Haube bildenden Seitenwandungen 202 des Gehäuses 200 bestehen ebenfalls aus Metall wie Kupfer oder Aluminium.

Während des Betriebs dringt hochkonzentriert Licht durch die Abdeckung 211 und trifft auf das Photovoltaikmodul, das aus den Solarzellen 201 und dem Träger 202 besteht. Die Lichtintensität ist ausreichend, um ungekühlte Metallstücke zu schmelzen. Es ist daher von Vorteil, eine gute Wärmeleitfähigkeit zwischen der Umfangswandung 220 zur Grundplatte 204 sicherzustellen. Die auch als Bodenwandung zu bezeichnende Grundplatte 204 hat direkten Kontakt zum Wasserfluss und wird daher aktiv gekühlt.

In Ausgestaltung der Erfindung kann erwähntermaßen die Rückseite des auch als Keramikplatte zu bezeichnenden Trägers 202 so ausgebildet sein, dass ein verbesserter Wärmeübergang zum Wasser gegeben ist. Üblicherweise ist die Rückseite einer entsprechenden Trägerplatte, die eine Keramikschicht aufweist, wie eine DCB-Platine, mit durchgehender Kupferschicht ausgebildet, die mit der Keramikschicht verbunden ist.

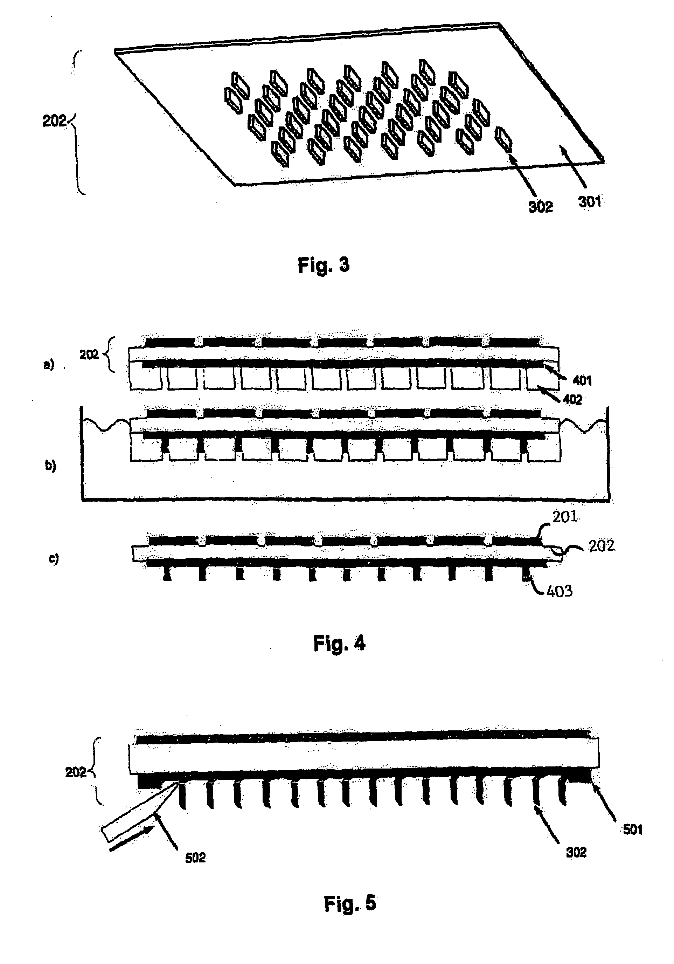

Entsprechend der Fig. 3 ist die Rückseite des Trägers 202 bzw. der Keramikplatte so aufgebaut, dass der Kontaktbereich zwischen dem Träger 202 und dem in dem Zwischenraum strömenden Wasser vergrößert und gleichzeitig eine turbulente Wasserströmung gefördert wird. Insbesondere kann die Rückseite 301 so aufgebaut sein, dass kleine Finnen 302 mit einer Höhe im Bereich zwischen 1 mm - 5 mm und engem Abstand vorliegen.

Diese Finnen oder Vorsprünge 302 können auch als Abstützung des Trägers 202, also als Abstützung auf der Oberseite der Grundplatte 204 dienen. In diesem Fall ist es nicht zwingend erforderlich, dass von der Grundplatte 204 Vorsprünge 206 abragen.

Die von der Rückseite 301 des Trägers 202 abragenden Vorsprünge oder Finnen 302 können entsprechen der Fig. 4 und 5 wie folgt ausgebildet werden. So besteht die Möglichkeit, eine Blende 402 mit einem Muster aus Spalten an der Rückseitenmetallisierung 401 des Trägers 202 zu befestigen. Die Rückseite 401 wird z.B. mit Kupfer galvanisiert oder chemisch beschichtet. Ein anderes geeignetes Metall kommt gleichfalls in Frage. Das sich ablagernde Metall füllt die Spalten in der Blende 402 oder Maske und bildet sodann die Finnen.

Nach Entfernen der Blende 402 verbleibt auf der Rückseite des Trägers 202 eine Anordnung der Finnen oder Vorsprünge.

Der Verfahrensablauf ist der Fig. 4 zu entnehmen. Die Finnen oder Vorsprünge sind mit dem Bezugszeichen 403 gekennzeichnet.

Gemäß Fig. 5 besteht auch die Möglichkeit, den Träger 202 mit einer recht dicken Rückseitenmetallisierung 501 mit z.B. einer Dicke von 1 mm zu versehen. Sodann werden Finnen 302 mittels eines mechanischen Werkzeugs 502 von der Rückseitenmetallisierung abgehoben bzw. abgeschält.

Es besteht aber auch die Möglichkeit, Abschnitte z.B. eines Metallbands oder Metalldrahts auf die Rückseitenmetallisierung 301 anzubringen wie zu schweißen, zu löten oder zu kleben. Maßnahmen wie Elektroschweißen, Ultraschallschweißen, Thermokompressionsschweißen, Löten, Direct Copper Bonding oder andere Verfahren können gleichfalls verwendet werden.

Ferner können die Finnen z.B. in einem Multilagensiebdruckverfahren aufgetragen und sodann gesintert werden.

## Patentansprüche

1. Anordnung zum Kühlen eines zumindest ein elektrisches und/oder elektronisches Bauelement aufweisenden Trägers (202), umfassend ein einen Innenraum (230) aufweisendes Gehäuse (200) mit
- einer den Boden des Gehäuses bildenden Grundplatte (204), wobei auf der Grundplatte der Träger abgestützt ist und zwischen dem Träger und der Grundplatte ein Kühlfluid führende Kanäle (205) verlaufen, die mit zumindest einer Einlass- und zumindest einer Auslassöffnung (207, 208) verbunden sind,
- einer den Träger umgebenden Umfangswandung (220) und
- einer oberhalb des Trägers verlaufenden und den Innenraum (230) des Gehäuses verschließenden Abdeckung (211),
**dadurch gekennzeichnet,**
**dass** der Innenraum (230) mit einem Gas mit einem Druck beaufschlagt ist, der größer als der durch das Kühlfluid erzeugte und auf den Träger (202) einwirkende Druck ist.

2. Anordnung nach Anspruch 1,
**dadurch gekennzeichnet,**
**dass** der Träger (202) ein Träger mit Solarzellen (201) ist.

3. Anordnung nach Anspruch 1,
**dadurch gekennzeichnet,**
**dass** von der Grundplatte (204) erste Vorsprünge wie Stege und/oder von grundplattenseitig verlaufender Unterseite (301, 501) des Trägers (202) zweite Vorsprünge (302) wie Lamellen ausgehen, und dass der Träger über die ersten und/oder die zweiten Vorsprünge auf der Grundplatte abgestützt ist.

4. Anordnung nach Anspruch 3,
**dadurch gekennzeichnet,**
**dass** die ersten und/oder zweiten Vorsprünge (302) die Kanäle (205) begrenzen.

5. Anordnung nach zumindest einem der vorhergehenden Ansprüche,
dadurch gekenntzeichnet,
dass die Unterseite (301, 401, 501) des Trägers (202) eine auf einem Keramikkörper aufgebrachte Metallisierung aufweist, auf der die zweiten Vorsprünge (302) ausgebildet sind.

6. Anordnung nach Anspruch 5,
dadurch gekenntzeichnet,
dass der Träger (202) über die von der Metallisierung ausgehenden zweiten Vorsprünge (302) auf der Grundplatte (204) abgestützt ist.

7. Anordnung nach zumindest einem der vorherigen Ansprüche,
**dadurch gekennzeichnet,**
**dass** der Innenraum (230) über ein vorzugsweise die Umfangswandung (220) durchsetzendes Entlüftungsventil (215) mit Umgebung der Anordnung verbunden ist,

8. Anordnung nach zumindest Anspruch 1,
**dadurch gekennzeichnet,**
**dass** die Abedeckung (211) transparent ist.

9. Anordnung nach zumindest einem der vorherigen Ansprüche,
**dadurch gekennzeichnet,**
**dass** der Innenraum (230) mit einem Gas wie Luft oder Stickstoff beaufschlagt ist, das getrocknet ist oder eine relative Luftfeuchtigkeit zwischen 0 % und 60 % aufweist.

10. Verfahren zum Kühlen eines zumindest ein elektrisches und/oder elektronisches Bauelement aufweisenden Trägers (202), wobei der Träger (202) in einem einen Innenraum (230) aufweisenden Gehäuse (200) mit
- einer den Träger (202) über Abstandselemente abstützenden Boden des Gehäuses bildenden Grundplatte (204),
- einer den Träger (202) umgebenden Umfangswandung (220) sowie
- einer den Innenraum des Gehäuses verschließenden, vorzugsweise transparenten, Abdeckung (211)
angeordnet wird, wobei zwischen dem Träger (202) und der Grundplatte (204) ein Zwischenraum vorhanden ist, der mit einem Kühlfluid durchströmt wird, mittels dessen der Träger (202) mit einem Druck P1 beaufschlagt wird,
**dadurch gekennzeichnet,**
**dass** der Innenraum mit einem Gas mit einem Druck P2 mit P2 ≥ P1 beaufschlagt wird.

11. Verfahren nach dem Anspruch 10,
**dadurch gekennzeichnet,**
**dass** als Träger (202) eine DCB-Platine verwendet wird.

12. Verfahren nach Anspruch 10,
**dadurch gekennzeichnet,**
**dass** das Kühlfluid mit einem Druck P mit 0,2 bar ≤ P ≤ 1 bar über Atmosphärendruck in den Zwischenraum eingeleitet wird und/oder Fließgeschwindigkeit V des dem Zwischenraum zugeführten Kühlfluids eingestellt wird auf 0,3 m/sec ≤ V ≤ 1 m/sec.

13. Verfahren nach Anspruch 10,
**dadurch gekennzeichnet,**
**dass** der Druck P2 auf einen Wert 1,2 P1 bis 2 P1 eingestellt wird.

14. Verfahren nach zumindest Anspruch 10, wobei der Träger zwischenraumseitig eine Metallisierung aufweist,
**dadurch gekennzeichnet,**
**dass** auf und/oder aus der Metallisierung sich in Richtung des Trägers (202) erstreckende Vorsprünge (302) ausgebildet werden, die insbesondere durch Galvanisieren in Maskentechnik oder stromloses Beschichten in Maskentechnik oder mechanisches Bearbeiten der Metallisierung oder durch Befestigen von aus Metall bestehenden streifenförmigen Elementen wie Metallbändern ausgebildet werden.

15. Verfahren nach Anspruch 10,
**dadurch gekennzeichnet,**
**dass** der Innenraum (230) über ein vorzugsweise die Umfangswandung (220) durchsetzendes Entlüftungsventil (215) mit der Umgebung der Anordnung verbunden wird.

## Claims

1. Arrangement for cooling a support (202) having at least one electric and/or electronic component, comprising a housing (200) having an interior space (230) with
- a base plate (204) forming the bottom of the housing, wherein the support is supported on the base plate, and channels (205) carrying a cooling fluid extend between the support and the base plate, channels which are connected to at least one inlet and to at least one outlet opening (207, 208),
- a peripheral wall (220) surrounding the support, and
- a cover (211) extending above the support and closing the interior space (230) of the housing,
**characterized in that**
the interior space (230) is subjected to a gas with a pressure that is greater than the pressure generated by the cooling fluid and exerted on the support (202).

2. Arrangement according to claim 1,
**characterized in that**
the support (202) is a support with solar cells (201).

3. Arrangement according to claim 1,
**characterized in that**
first protrusions, such as webs, originate from the base plate (204), and/or second protrusions (302), such as lamellas, start from the bottom side (301, 501) of the support (202) extending on the base plate side, and that the support is supported on the base plate via the first and/or the second protrusions.

4. Arrangement according to claim 3,
**characterized in that**
the first and/or second protrusions (302) delimit the channels (205).

5. Arrangement according to at least one of the previous claims,
**characterized in that**
the bottom side (301, 401, 501) of the support (202) comprises a metallization applied to a ceramic body, wherein the second protrusions (302) are formed on the metallization.

6. Arrangement according to claim 5,
**characterized in that**
the support (202) is supported on the base plate (204) via the second protrusions (302) starting out from the metallization.

7. Arrangement according to at least one of the previous claims,
**characterized in that**
the interior space (230) is connected via a ventilation valve (215) which preferably passes through the circumferential wall (220) to environment of the arrangement.

8. Arrangement according to at least claim 1,
**characterized in that**
the cover (211) is transparent.

9. Arrangement according to at least one of the previous claims,
**characterized in that**
the interior space (230) is subjected to a gas, such as air or nitrogen, which is dried or which has a relative air humidity between 0% and 60%.

10. Method for cooling a support (202) having at least one electric and/or electronic component, wherein the support (202) is arranged in a housing (200) comprising an interior space (230) with
- a base plate (204) forming the bottom of the housing, wherein the bottom supports the support (202) via spacer elements,
- a circumferential wall (220) surrounding the support (202), as well as
- a preferably transparent cover (211) closing the interior space of the housing,
wherein, between the support (202) and the base plate (204), an interstice is present, through which a cooling fluid flows, by means of which the support (202) is subjected to a pressure P1,
**characterized in that**
the interior space is subjected to a gas at a pressure P2 where P2 ≥ P1.

11. Method according to claim 10,
**characterized in that**
a DCB circuit board is used as support (202).

12. Method according to claim 10,
**characterized in that**
the cooling fluid at a pressure P where 0.2 bar ≤ P ≤1 bar above atmospheric pressure is introduced into the interstice and/or the flow rate V of the cooling fluid supplied to the interstice is set to 0.3 m/sec ≤ V ≤ 1 m/sec.

13. Method according to claim 10,
**characterized in that**
the pressure P2 is set to a value of 1.2 P1 to 2 P1.

14. Method according to at least claim 10, wherein the support on the interstice side has a metallization,
**characterized in that**
on and/or from the metallization, protrusions (302) extending in the direction of the support (202) are formed, which are formed in particular by galvanization in the masking technique, or current-free coating in the masking technique, or mechanical processing of the metallization, or by securing strip-shaped elements made of metal, such as metal bands.

15. Method according to claim 10,
**characterized in that**
the interior space (230) is connected via a ventilation valve (215) which preferably passes through the circumferential wall (220) to environment of the arrangement.

## Revendications

1. Dispositif pour refroidir un support (202) présentant au moins un composant électrique et/ou électronique, ledit dispositif comprenant un boîtier (200) présentant un espace intérieur (230), avec
- une plaque de base (204) formant le fond du boîtier, sachant que le support s'appuie sur la plaque de base et qu'entre le support et la plaque de base sont disposés des conduits (205) qui conduisent un fluide réfrigérant et sont reliés à au moins un orifice d'entrée et à au moins un orifice de sortie (207, 208),
- une paroi périphérique (220) entourant le support et
- un couvercle (211) s'étendant sur le dessus du support et fermant l'espace intérieur (230) du boîtier,
**caractérisé en ce**
**que** l'espace intérieur (230) est alimenté par un gaz sous une pression supérieure à la pression engendrée par le fluide réfrigérant et agissant sur le support (202).

2. Dispositif selon la revendication 1,
**caractérisé en ce**
**que** le support (202) est un support comportant des cellules solaires (201).

3. Dispositif selon la revendication 1,
**caractérisé en ce**
**que** de la plaque de base (204) partent des premières parties saillantes telles que des nervures et/ou que de la face inférieure (301, 501) du support (202) s'étendant en face de la plaque de base partent des secondes parties saillantes (302) telles que des lamelles, et que le support s'appuie sur la plaque de base par l'intermédiaire des premières et/ou des secondes parties saillantes.

4. Dispositif selon la revendication 3,
**caractérisé en ce**
**que** les premières et/ou secondes parties saillantes (302) délimitent les conduits (205).

5. Dispositif selon au moins un des revendications précédentes,
**caractérisé en ce**
**que** la face inférieure (301, 401, 501) du support (202) présente une métallisation appliquée sur un corps en céramique et sur laquelle sont formées les secondes parties saillantes (302).

6. Dispositif selon la revendication 5,
**caractérisé en ce**
**que** le support (202) s'appuie sur la plaque de base (204) par l'intermédiaire des secondes parties saillantes (302) partant de la métallisation.

7. Dispositif selon au moins un des revendications précédentes,
**caractérisé en ce**
**que** l'espace intérieur (230) est relié à l'environnement du dispositif par une valve de dégazage (215) traversant de préférence la paroi périphérique (220).

8. Dispositif selon au moins la revendication 1,
**caractérisé en ce**
**que** le couvercle (211) est transparent.

9. Dispositif selon au moins un des revendications précédentes,
**caractérisé en ce**
**que** l'espace intérieur (230) est alimenté par un gaz tel que de l'air ou de l'azote qui est séché ou présente une humidité relative comprise entre 0 % et 60 %.

10. Procédé pour refroidir un support (202) présentant au moins un composant électrique et/ou électronique, sachant que le support (202) est disposé dans un boîtier (200) présentant un espace intérieur (230), avec
- une plaque de base (204) formant le fond du boîtier et servant d'appui au support (202) par l'intermédiaire d'éléments d'espacement,
- une paroi périphérique (220) entourant le support (202), ainsi
- qu'un couvercle (211) de préférence transparent fermant l'espace intérieur du boîtier,
sachant qu'entre le support (202) et la plaque de base (204) se trouve un espace intermédiaire qui est traversé par un fluide réfrigérant au moyen duquel le support (202) est alimenté sous une pression P1,
**caractérisé en ce**
**que** l'espace intérieur est alimenté par un gaz sous une pression P2 telle que P2 ≥ P1.

11. Procédé selon la revendication 10,
**caractérisé en ce**
**qu'**une platine DCB (Direct Copper Bonding, procédé de métallisation directe au cuivre) est utilisée en tant que support.

12. Procédé selon la revendication 10,
**caractérisé en ce**
**que** le fluide réfrigérant est introduit dans l'espace intermédiaire sous une pression P telle que 0,2 bar ≤ P ≤ 1 bar au-dessus de la pression atmosphérique et/ou que la vitesse d'écoulement V du fluide réfrigérant introduit dans l'espace intermédiaire est ajustée à 0,3 m/s ≤ V ≤ 1 m/s.

13. Procédé selon la revendication 10,
**caractérisé en ce**
**que** la pression P2 est ajustée à une valeur comprise entre 1,2×P1 et 2×P1.

14. Procédé selon au moins la revendication 10, dans lequel le support présente une métallisation du côté de l'espace intermédiaire,
**caractérisé en ce**
**que** sur et/ou à partir de la métallisation sont formées des parties saillantes (302) qui s'étendent en direction du support (202) et sont façonnées en particulier par électrogalvanisation selon la technique de masquage ou par revêtement sans courant selon la technique de masquage ou par traitement mécanique de la métallisation ou par fixation d'éléments en métal en forme de bande tels que des rubans métalliques.

15. Procédé selon la revendication 10,
**caractérisé en ce**
**que** l'espace intérieur (230) est relié à l'environnement du dispositif par une valve de dégazage (215) traversant de préférence la paroi périphérique (220).
